# EUROPEAN PATENT SPECIFICATION

(11) **EP 2 290 681 B1**
(45) Date of publication and mention of the grant of the patent: **05.09.2018**
(21) Application number: 10251367.8
(22) Date of filing: 30.07.2010
(51) Int. Cl.: H01L 23/427, H01L 23/467, H05K 7/20

(54) **Power conversion device**
Leistungswandlungsvorrichtung
Dispositif de conversion de puissance

(30) Priority: 27.08.2009 JP 2009196215
(43) Date of publication of application: 02.03.2011
(73) Proprietor: Hitachi, Ltd., Chiyoda-ku Tokyo 100-8280 (JP)
(72) Inventor: Funakoshi, Sunao, Tokyo 100-8220 (JP); Suzuki, Osamu, Tokyo 100-8220 (JP); Yasuda, Yosuke, Tokyo 100-8220 (JP); Tanaka, Takeshi, Tokyo 100-8220 (JP); Hishida, Akihiro, Tokyo 100-8220 (JP); Yamaguchi, Satoshi, Tokyo 100-8220 (JP)
(74) Representative: Gill, Stephen Charles

(56) References cited:
- JP-A- 10 038 482
- JP-A- 10 223 814
- JP-A- 11 241 893
- JP-A- 11 251 499
- JP-A- 2000 150 748
- JP-A- 2001 251 859
- JP-A- 2004 254 387

## Description

### BACKGROUND OF THE INVENTION

### Field of the invention

The present invention relates to a power conversion device.

### Description of the related art

A power conversion device is a device for controlling an electric motor driving an electric railway vehicle, which is disposed under the floor of a vehicle, for example. Since the space under the floor of the vehicle is limited, it is desirable that the power conversion device has a small size. As disclosed in patent document 1, a known prior art power conversion device has heat receiving sections of L-shaped heat pipes arranged so as to be thermally in contact with a heat receiving member, wherein heat radiating sections erected from the heat receiving sections of the heat pipes are arranged in a zigzag manner, to thereby improve the heat radiating performance.

[Patent document 1] Japanese patent application laid-open publication No. 11-251499

JP 10 223814 A proposes a heat pipe-type heat sink for cooling semiconductor elements. JP 11 241893 A proposes another semiconductor element cooling device. JP 2001 251859 A and JP 2004 254387 A propose power converters. JP 2000 150748 A proposes a semiconductor circuit cooling device for a vehicle.

The prior art arrangement had a drawback in that the heat receiving sections of the heat pipes do not cover the whole area of the heat receiving member, so that cooling could not be performed sufficiently in some areas of the heat receiving member, causing high temperature areas to occur.

### SUMMARY OF THE INVENTION

The present invention aims at solving the problems of the prior art by providing a small-sized power conversion device capable of sufficiently cooling the heat receiving member, and thus, sufficiently cooling the power semiconductor devices.

In order to achieve the above-mentioned aim, the present invention provides a power conversion device according to claim 1.

By adopting this arrangement, it becomes possible to ensure a sufficient contact area between the heat radiating sections of the heat pipes and the fins, and to arrange the heat receiving sections of the heat pipes to cover the whole area of the heat receiving member, according to which the whole area of the heat receiving member can be cooled effectively, and the power conversion device can be downsized.

### BRIEF DESCRIPTION OF THE DRAWINGS

FIG. 1 is a horizontal cross-sectional view of a power conversion device according to a preferred embodiment of the present invention;
FIG. 2 is a vertical cross-sectional view of the power conversion device according to a preferred embodiment of the present invention;
FIG. 3 is a view showing the arrangement of heat pipes according to a preferred embodiment of the present invention;
FIGS. 4A and 4B are views showing the results of numerical simulation of the cooling performance of the power conversion device according to a prior art arrangement and of the power conversion device according to the arrangement of a preferred embodiment of the present invention;
FIG. 5 is a view showing an arrangement according to one example of a power conversion device of the prior art;
FIG. 6 is a view showing the arrangement of the power semiconductor devices and the heat pipes according to a preferred embodiment of the present invention;
FIG. 7 is a view showing the arrangement of heat pipes of a power conversion device according to another preferred embodiment of the present invention;
FIG. 8 is a view showing the arrangement of heat pipes of the power conversion device according to another preferred embodiment of the present invention;
FIG. 9 is a view showing the arrangement of heat pipes of the power conversion device according to another preferred embodiment of the present invention;
FIG. 10 is a view showing the arrangement of a power conversion device according to yet another preferred embodiment of the present invention; and
FIG. 11 is a view showing the arrangement in which the power conversion device according to the present invention is disposed on a railway vehicle.

### DETAILED DESCRIPTION OF THE PREFERRED EMBODIMENTS

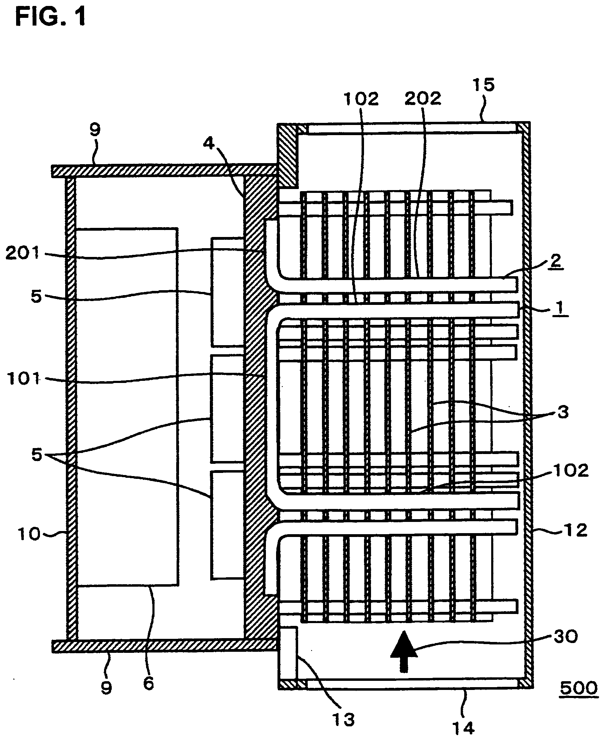

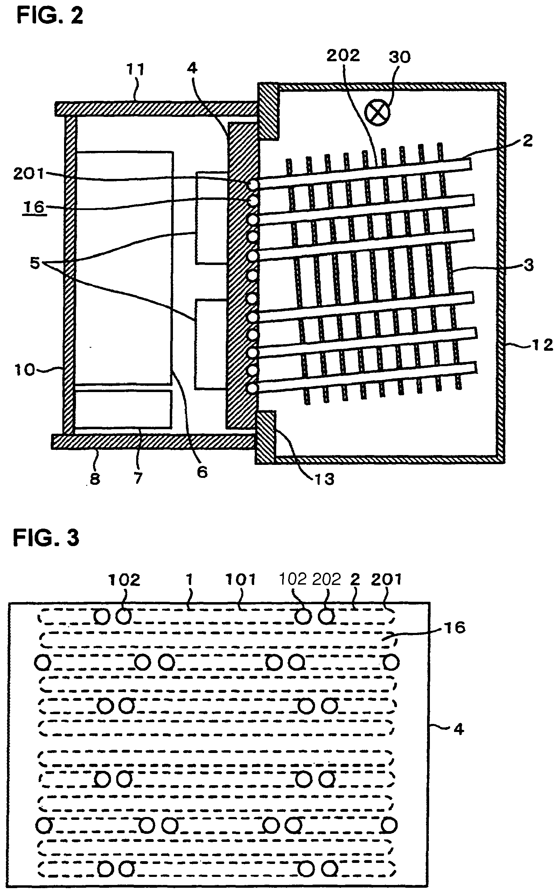

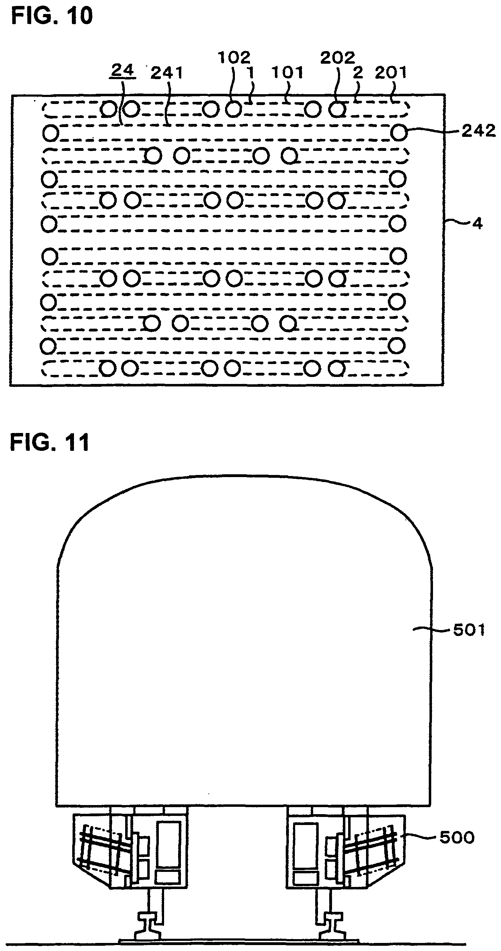

Now, the preferred embodiments for carrying out the present invention will be described with reference to the drawings . FIG. 11 illustrates a structure in which a power conversion device according to one preferred embodiment of the present invention is disposed on a railway vehicle. The power conversion device according to the present invention is disposed under a floor of a railway vehicle, for controlling the rotation speed of an electric motor by varying the frequency of the power supplied to the electric motor for driving the vehicle. In FIG.11, the power conversion device 500 is suspended below a car body 501 and secured thereto. FIG. 1 is a horizontal cross-sectional view of the power conversion device according to the present embodiment, and FIG. 2 is a perpendicular cross-sectional view thereof. As shown in FIGS. land 2, on one side of a heat receiving member 4 composed of metallic material such as aluminum alloy are disposed multiple power semiconductor devices such as IGBTs (insulated gate bipolar transistors), and power semiconductor modules 5 including FWDs (free wheel diodes) connected in parallel therewith. Further, the plurality of power semiconductor modules 5 constitute an inverter. The power semiconductor modules 5 are fixed via a member such as a grease (not shown) to the heat receiving member 4 using screws or the like (not shown) . The heat receiving member 4 is fixed to the support member 13. Electronic components such as a filter capacitor 6 and an IGBT drive circuit 7 are disposed on the support member 13 on the side of the power semiconductor modules 5. Further, the side of the power conversion device on which the power semiconductor modules are installed is airtightly sealed via case 8, 9, 10 and 11. A heat receiving section 101 of a U-shaped heat pipe 1 is embedded in the heat receiving member 4 on the opposite side from where the power semiconductor modules are disposed, which is thermally connected via soldering or the like to the heat receiving member 4. Similarly, a heat receiving section 201 of an L-shaped heat pipe 2 is also embedded in the heat receiving member 4 and connected thereto via soldering or the like. Heat radiating sections 102 are erected from the heat receiving member 4 on both ends of the U-shaped heat pipe 1. Further, a heat radiating section 202 is erected from one end of the L-shaped heat pipe 2. A plurality of fins 3 are disposed on the heat radiating sections 102 and 202. A cover 12 is disposed on the side having the heat pipe 1 of the support member 13. An opening can be disposed on a portion of the cover 12. When the vehicle is running, the air taken in through an air inlet 14 flows in the direction of arrow 30, and discharged through an air outlet 15. When the vehicle runs in the opposite direction, the direction of the air flow becomes opposite. Further, a structure can be adopted in which the air is forcibly blown via a cooling fan. As described, by having air flow through the fins 3, heat is radiated from the fins 3 to the air.

Next, we will describe the operation for cooling the power semiconductor module 5. The heat generated for example by the operation of the power semiconductors disposed inside the power semiconductor module 5 is transmitted to the heat receiving member 4, and reaches the heat receiving section 101 of the heat pipe 1. A refrigerant (such as pure water or hydrofluorocarbon) is sealed in the heat pipe 1. The refrigerant heated in the heat receiving section 101 is evaporated and turned into gas, and moves to the heat radiating sections 102. The refrigerant cooled by air in the heat radiating sections 102 is condensed and returned to liquid. As shown in FIG. 2, the heat radiating section 102 is gently inclined for approximately 10 degrees, so that the refrigerant condensed in the heat radiating section 102 is returned to the heat receiving section by gravity. As described, the refrigerant is moved via repeated evaporation and condensation, by which the heat of the heat receiving member 4 is radiated to the air.

FIG. 3 shows the shapes and arrangements of the heat pipes of the heat receiving member 4. U-shaped heat pipes 1 and 21 and L-shape heat pipes 2 are arranged, and respective heat radiating sections 102 and 202 are arranged in a zigzag manner. Further, in addition to the L-shaped and U-shaped heat pipes, heat averaging pipes 16 not having heat radiating sections erected from the heat receiving member are disposed for averaging heat. The heat averaging pipes 16 enable heat to spread within the whole heat receiving member, thereby preventing high temperature portions to be generated at local areas. According to this heat pipe arrangement, the heat pipes can be embedded across the whole area of the heat receiving member 4, and since the heat radiating sections of the heat pipes are arranged in a zigzag manner, a large number of heat pipes coming in contact with the heat radiating fins 3 can be arranged in a dispersed manner with a small ventilation resistance, so that the cooling performance of the power semiconductor device can be improved significantly, and the device can be downsized.

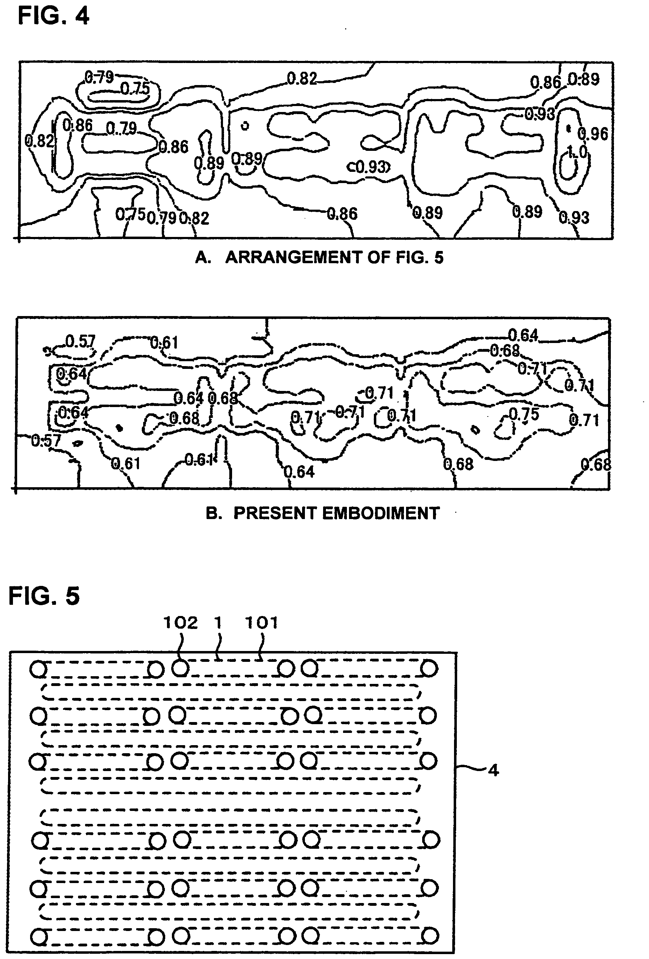

The cooling performances of the arrangement according to the present embodiment and the arrangement shown in FIG. 5 in which the U-shaped heat pipes are arranged in line were compared via numerical simulation. FIG. 4A shows the result of simulation of the heat receiving member surface temperature distribution according to the arrangement of FIG. 5, and FIG. 4B shows the result of simulation according to the present embodiment. FIG. 4 shows the normalized temperatures in which the maximum temperature difference between the air and the heat receiving member is set as one. As can be seen from FIG. 4, compared to the arrangement in which the heat pipe is arranged in line (FIG. 4A), the maximum temperature according to the arrangement of the present embodiment (FIG. 4B) is suppressed to a low value. This result shows that according to the present embodiment having a small ventilation resistance, the wind speed passing through the fins can be increased, and since the heat radiating sections are arranged in a dispersed manner, the cooling performance of the power semiconductors has been improved.

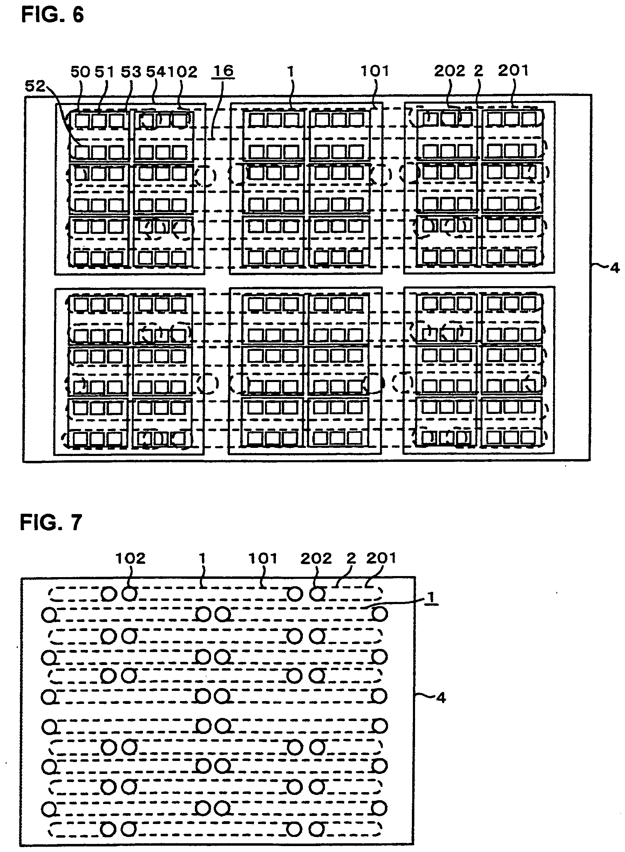

FIG. 6 shows the arrangement of the power semiconductor devices and the heat pipes on the heat receiving member according to the present embodiment. In FIG. 6, reference numbers 50, 51 and 52 denote power semiconductor devices, 53 denotes an insulating substrate, and 54 denotes a heat radiation panel. The power semiconductor devices, the insulating substrate and the heat radiation panel are disposed in the interior of the power semiconductor modules 5 illustrated in FIGS. 1 and 2. The insulating substrate 53 has a wiring pattern formed for example of aluminum attached to a surface of an insulating material such as aluminum nitride, and the power semiconductor devices are attached for example to the wiring pattern via soldering. A thin aluminum panel is joined to the opposite side of the insulating substrate, wherein the aluminum panel and the heat radiation panel 54 are joined for example via soldering. The heat radiating panel 54 is formed of copper, AlSiC or other material having a relatively high heat conductivity, functioning also to diffuse the heat of the semiconductor devices in the horizontal direction. The power semiconductor devices are disposed along the heat receiving section of the heat pipes via the heat receiving member 4, as shown in FIG. 6.

In FIG. 6, the distance between semiconductor devices 50 and 51 is small, and the distance between semiconductor devices 50 and 52 is somewhat large. Therefore, the direction in which the power semiconductor devices are arranged densely corresponds to the longitudinal direction of the heat pipe. Furthermore, the distance between the heat pipes is varied to correspond to the arrangement of the power semiconductor devices, so that the position of the power semiconductor devices on the heat receiving member substantially overlaps with the position of the heat pipes on the heat receiving member. By arranging the semiconductor devices and the heat pipes in this manner, the semiconductor devices can be arranged close to the heat pipes, so that the heat generated from the semiconductor devices can be transmitted more efficiently to the heat pipes.

As described, the present embodiment enables the cooling performance of the power semiconductor devices to be improved significantly, and to downsize the device.

FIG. 7 is a power conversion device according to another embodiment of the present invention. FIG. 7 shows the heat receiving member 4 and the arrangement of heat pipes on the heat receiving member 4. The arrangements of the portion not shown in FIG. 7 are the same as those of the first embodiment. As shown in FIG. 7, according to the present embodiment, the heat averaging pipe having no erected portion has been omitted, and all the heat pipes are composed of L-shaped and U-shaped heat pipes. The pipes of the heat radiating sections (102, 202 and the like) erected from the heat block are arranged in a zigzag manner. Since there are only two types of heat pipes used in the present embodiment, the manufacturing costs can be cut down. According to the present embodiment, the heat pipes can be embedded across the whole area of the heat receiving member 4, and a large number of heat pipes being in contact with the heat radiating fins 3 can be arranged in a dispersed manner with minimal ventilation resistance, so that the cooling performance of the power semiconductor devices can be improved significantly, and the device can be downsized.

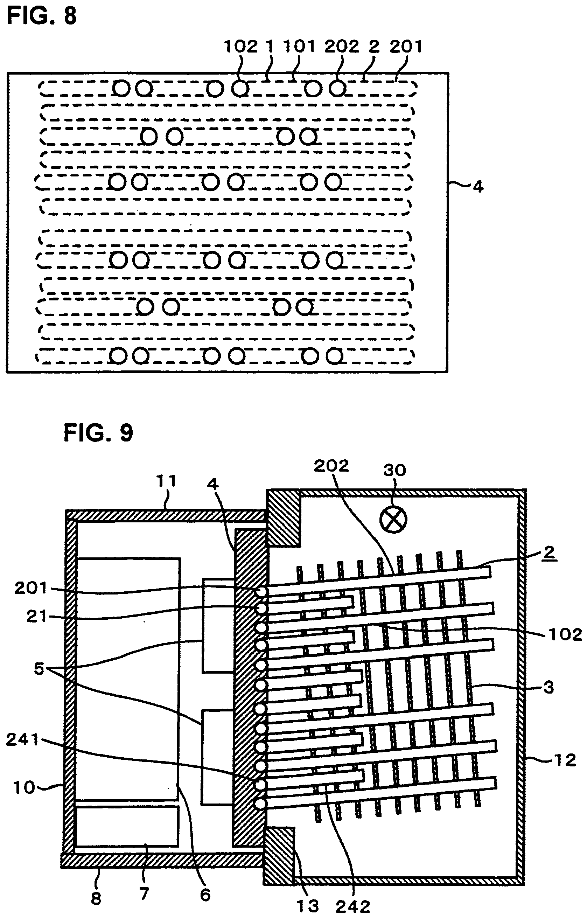

FIG. 8 shows a power conversion device according to yet another embodiment of the present invention. FIG. 8 shows the arrangement of a heat receiving member 4, and heat pipes disposed on the heat receiving member 4. The arrangements not shown in FIG. 8 are the same as those of the first embodiment . As shown in FIG. 8, the pipes arranged at the end sections are all L-shaped pipes, according to which the pipes can be embedded in a more compact manner across the whole area of the heat receiving member 4, according to which the device can be downsized.

FIG. 9 illustrates a power conversion device according to yet another embodiment of the present invention, and FIG. 10 illustrates the arrangement of heat pipes on the heat receiving member 4 according to the power conversion device of the present embodiment. In FIGS. 9 and 10, the heat pipes 24 are equipped with heat radiating sections 242 composed of short heat pipes erected from the heat receiving sections 241 to the outer side of the heat receiving members.

In order to prevent the increase of ventilation resistance caused by disposing the heat radiating sections 242 on both ends of the heat pipe 24, the heat pipes arranged adjacent the heat pipes 24 at the end sections of the heat receiving member 4 are L-shaped heat pipes 2. According to the present embodiment, even when the surrounding temperature of the device is below 0 degrees in a cold region, the heat pipes having short heat radiating sections only have a small heat radiation quantity, so that the pipes continue to function as heat pipes without freezing, so that the temperature of the power semiconductors will not be increased excessively even in a cold region, and a stable startup can be realized. Further according to the present embodiment, the heat pipes can be embedded across the whole area of the heat receiving member 4, and a large number of heat pipes coming in contact with the radiating fins 3 can be arranged in a dispersed manner while suppressing the ventilation resistance, so that the cooling performance of the power semiconductor devices can be improved significantly, and the device can be downsized.

## Claims

1. A power conversion device (500) comprising a plurality of power semiconductor devices (50, 51, 52), a heat receiving member (4), a plurality of heat pipes (1, 2) and a plurality of heat radiating fins (3), wherein
the plurality of power semiconductor devices are attached to one side of the heat receiving member;
the plurality of heat pipes are connected to the other side of the heat receiving member via heat receiving sections (101, 201) of the heat pipes;
the plurality of heat pipes are composed of a variety of heat pipes having two or more different shapes;
one variety of the plurality of heat pipes is a U-shaped heat pipe (1) having heat radiating sections (102) erected from both sides of its heat receiving section (101) to an outer side of the heat receiving member, and the other variety of the plurality of heat pipes is an L-shaped heat pipe (2) having a heat radiating section (202) erected from one side of its heat receiving section to the outer side of the heat receiving member;
each L-shaped heat pipe is located adjacent an upstream or downstream edge of the heat receiving member relative to a direction (30) of cooling air flow;
the plurality of heat radiating fins are disposed on the heat radiating sections of the plurality of heat pipes;
the heat radiating sections of the heat pipes are arranged in a zigzag manner;
each L-shaped heat pipe has its heat radiating section (202) erected from an end of its heat receiving section (201) which is distal from the respective adjacent edge;
the L-shaped heat pipes are in pairs, the L-shaped heat pipes of each pair being located adjacent respective and opposing portions of the upstream and downstream edges of the heat receiving member; and
one or two of the U-shaped heat pipes are arranged between each of said pairs of L-shaped heat pipes.

2. The power conversion device according to claim 1, wherein
the power conversion device comprises a heat averaging pipe (16) attached to the other side of the heat receiving member, having no heat radiating section erected from the heat receiving section to the outer side of the heat receiving member.

3. The power conversion device according to claim 1 or 2, wherein
the power conversion device comprises an insulating substrate (53) for mounting the plurality of power semiconductor devices, and a heat radiating panel (54) for mounting the plurality of insulating substrates;
the power semiconductor devices are mounted on one side of the insulating substrate;
the opposite side of the insulating substrate is connected to the heat radiating panel;
the heat radiating panel is connected to the heat receiving member;
the plurality of power semiconductor devices are arranged relatively densely in a longitudinal direction of the heat pipe;
the plurality of power semiconductor devices are arranged relatively sparsely in a direction orthogonal to the heat pipe; and
the plurality of power semiconductor devices and the heat pipes are arranged so that positions of the densely arranged power semiconductor devices on the heat receiving member and positions of the heat pipes on the heat receiving member are overlapped.

4. The power conversion device according to any one of claims 1 to 3, wherein
a further portion of the plurality of heat pipes (24) have a heat radiating section (242) shorter than the heat radiating section of other heat pipes.

## Patentansprüche

1. Leistungsumwandlungsvorrichtung (500), umfassend eine Vielzahl von Leistungshalbleitervorrichtungen (50, 51, 52), ein Wärmeaufnahmeelement (4), eine Vielzahl von Wärmerohren (1, 2) und eine Vielzahl von Wärmeabstrahlrippen (3), worin
die Vielzahl von Leistungshalbleitervorrichtungen an einer Seite des Wärmeaufnahmeelements angebracht sind;
die Vielzahl von Wärmerohren mit der anderen Seite des Wärmeaufnahmeelements über Wärmeaufnahmeabschnitte (101, 201) der Wärmerohre verbunden sind;
die Vielzahl von Wärmerohren aus einer Varietät von Wärmerohren besteht, die zwei oder mehrere unterschiedliche Formen aufweisen;
wobei eine Varietät aus der Vielzahl von Wärmerohren ein U-förmiges Wärmerohr (1) ist, das Wärmeabstrahlabschnitte (102) aufweist, die von beiden Seiten von dessen Wärmeaufnahmeabschnitt (101) zu einer Außenseite des Wärmeaufnahmeelements hin aufrecht angeordnet sind, und die andere Varietät aus der Vielzahl von Wärmerohren ein L-förmiges Wärmerohr (2) ist, das einen Wärmeabstrahlausschnitt (202) aufweist, der von einer Seite von dessen Wärmeaufnahmeabschnitt zur Außenseite des Wärmeaufnahmeelements hin aufrecht angeordnet ist;
wobei jedes L-förmige Wärmerohr angrenzend an eine stromaufwärtige oder eine stromabwärtige Kante des Wärmeaufnahmeelements relativ zu einer Richtung (30) eines Kühlluftstroms positioniert ist;
wobei die Vielzahl von Wärmeabstrahlrippen auf den Wärmeabstrahlabschnitten aus der Vielzahl von Wärmerohren angeordnet ist;
wobei die Wärmeabstrahlabschnitte der Wärmerohre zick-zack-förmig angeordnet sind;
wobei jedes L-förmige Wärmerohr seinen Wärmeabstrahlabschnitt (202) von einem Ende seines Wärmeaufnahmeabschnitts (201), der von der jeweiligen angrenzenden Kante distal angeordnet ist, aufrecht angeordnet aufweist;
wobei die L-förmigen Wärmerohre paarweise angeordnet sind, worin die L-förmigen Wärmerohre von jedem Paar angrenzend an einen jeweiligen und gegenüberliegenden Abschnitt der stromaufwärtigen und der stromabwärtigen Kante des Wärmeaufnahmeelements positioniert sind; und
wobei eines oder zwei der U-förmigen Wärmerohre zwischen jedem der L-förmigen Wärmerohr-Paare angeordnet sind.

2. Leistungsumwandlungsvorrichtung gemäß Anspruch 1, worin
die Leistungsumwandlungsvorrichtung ein Wärmemittelwertbildungsrohr (16) umfasst, das an der anderen Seite des Wärmeaufnahmeelements angebracht ist, und keinen Wärmeabstrahlabschnitt aufweist, der vom Wärmeaufnahmeabschnitt zur Außenseite des Wärmeaufnahmeelements hin aufrecht angeordnet ist.

3. Leistungsumwandlungsvorrichtung gemäß Anspruch 1 oder 2,
worin die Leistungsumwandlungsvorrichtung ein Isoliersubstrat (53) zum Befestigen der Vielzahl von Leistungshalbleitervorrichtungen und eine Wärmeabstrahlplatte (54) zum Befestigen der Vielzahl von Isoliersubstraten umfasst;
worin die Leistungshalbleitervorrichtungen auf einer Seite des Isoliersubstrats befestigt sind;
worin die gegenüberliegende Seite des Isoliersubstrats mit der Wärmeabstrahlplatte verbunden ist;
worin die Wärmeabstrahlplatte mit dem Wärmeaufnahmeelement verbunden ist;
worin die Vielzahl von Leistungshalbleitervorrichtungen relativ dicht in einer Längsrichtung des Wärmerohrs angeordnet ist;
worin die Vielzahl von Leistungshalbleitervorrichtungen relativ spärlich in einer zum Wärmerohr orthogonalen Richtung angeordnet ist; und
worin die Vielzahl von Leistungshalbleitervorrichtungen und die Wärmerohre derart angeordnet sind, dass Positionen der dicht angeordneten Leistungshalbleitervorrichtungen auf dem Wärmeaufnahmeelement und Positionen der Wärmerohre des Wärmeaufnahmeelements überlappt sind.

4. Leistungsumwandlungsvorrichtungen gemäß einem der Ansprüche 1 bis 3,
worin ein weiterer Abschnitt aus der Vielzahl von Wärmerohren (24) einen Wärmeabstrahlabschnitt (242) aufweist, der kürzer als der Wärmeabstrahlabschnitt von anderen Wärmerohren ist.

## Revendications

1. Dispositif de conversion de puissance (500) comprenant une pluralité de dispositifs à semi-conducteurs de puissance (50, 51, 52), un élément de réception de chaleur (4), une pluralité de caloducs (1, 2) et une pluralité d'ailettes de rayonnement de chaleur (3), dans lequel
la pluralité de dispositifs à semi-conducteurs de puissance sont attachés à un côté de l'élément de réception de chaleur ;
la pluralité de caloducs sont reliés à l'autre côté de l'élément de réception de chaleur par l'intermédiaire des sections de réception de chaleur (101, 201) des caloducs ;
la pluralité de caloducs sont composés de divers caloducs ayant deux formes différentes ou plus ;
une variété de la pluralité de caloducs consiste en un caloduc en forme de U (1) comportant des sections de rayonnement de chaleur (102) dressées des deux côtés de sa section de réception de chaleur (101) jusqu'à un côté extérieur de l'élément de réception de chaleur, et l'autre variété de la pluralité de caloducs consiste en un caloduc en forme de L (2) comportant une section de rayonnement de chaleur (202) dressée d'un côté de sa section de réception de chaleur jusqu'au côté extérieur de l'élément de réception de chaleur ;
chaque caloduc en forme de L est situé adjacent à un bord amont ou aval de l'élément de réception de chaleur en relation avec une direction (30) de circulation d'air de refroidissement ;
la pluralité d'ailettes de rayonnement de chaleur sont disposées sur les sections de rayonnement de chaleur de la pluralité de caloducs ;
les sections de rayonnement de chaleur des caloducs sont agencées en zigzag ;
chaque caloduc en forme de L a sa section de rayonnement de chaleur (202) dressée à partir d'une extrémité de sa section de réception de chaleur (201) qui est à distance du bord adjacent respectif ;
les caloducs en forme de L sont par paires, les caloducs en forme de L de chaque paire étant situés adjacents aux parties respectives et opposées des bords amont et aval de l'élément de réception de chaleur ; et
un ou deux des caloducs en forme de U sont agencés entre chacune desdites paires de caloducs en forme L.

2. Dispositif de conversion de puissance selon la revendication 1, dans lequel
le dispositif de conversion de puissance comprend un tuyau de moyennage de chaleur (16) attaché à l'autre côté de l'élément de réception de chaleur, n'ayant pas de section de rayonnement de chaleur dressée de la section de réception de chaleur jusqu'au côté extérieur de l'élément de réception de chaleur.

3. Dispositif de conversion de puissance selon la revendication 1 ou 2, dans lequel
le dispositif de conversion de puissance comprend un substrat isolant (53) pour le montage de la pluralité de dispositifs à semi-conducteurs de puissance, et un panneau de rayonnement de chaleur (54) pour le montage de la pluralité de substrats isolants ;
les dispositifs à semi-conducteurs de puissance sont montés sur un côté du substrat isolant ;
le côté opposé du substrat isolant est relié au panneau de rayonnement de chaleur ;
le panneau de rayonnement de chaleur est relié à l'élément de réception de chaleur ;
la pluralité de dispositifs à semi-conducteurs de puissance sont agencés de manière relativement dense dans une direction longitudinale du caloduc ;
la pluralité de dispositifs à semi-conducteurs de puissance sont agencés de manière relativement peu dense dans une direction orthogonale au caloduc ; et
la pluralité de dispositifs à semi-conducteurs de puissance et les caloducs sont agencés de sorte que les positions des dispositifs à semi-conducteurs de puissance agencés de manière dense sur l'élément de réception de chaleur et les positions des caloducs sur l'élément de réception de chaleur se chevauchent.

4. Dispositif de conversion de puissance selon l'une quelconque des revendications 1 à 3, dans lequel
une autre partie de la pluralité de caloducs (24) ont une section de rayonnement de chaleur (242) plus courte que la section de rayonnement de chaleur des autres caloducs.
